(19) Europäisches Patentamt / European Patent Office / Office européen des brevets

(11) **EP 1 046 975 B1**

(12) **EUROPEAN PATENT SPECIFICATION**

(45) Date of publication and mention
of the grant of the patent:
**13.05.2015 Bulletin 2015/20**

(51) Int Cl.:
**G05F 1/577** *(2006.01)*

(21) Application number: **00400579.9**

(22) Date of filing: **03.03.2000**

(54) **Device and a method of supplying power to plurality of semiconductor integrated circuit devices**

Verfahren und Einrichtung zur Spannungsversorgung einer Mehrzahl von Halbleiterelementen

Procédé et dispositif pour l'alimentation d'une pluralité d'éléments semi-conducteurs

(84) Designated Contracting States:
**DE FR**

(30) Priority: **19.04.1999 JP 11144499**

(43) Date of publication of application:
**25.10.2000 Bulletin 2000/43**

(73) Proprietor: **Spansion LLC**
**Sunnyvale, CA 94085 (US)**

(72) Inventor: **Nunokawa, Hideo,**
**c/o Fujitsu Limited**
**Kawasaki-shi,**
**Kanagawa 211-8588 (JP)**

(74) Representative: **Brookes Batchellor LLP**
**1 Boyne Park**
**Tunbridge Wells Kent TN4 8EL (GB)**

(56) References cited:
**EP-A- 0 686 902     US-A- 5 812 860**
**US-A- 5 861 771**

**Description**

FIELD OF THE INVENTION

The present invention relates to a semiconductor integrated circuit device, an electronic circuit, a system board with the semiconductor integrated circuit device provided therein and a method of supplying power to a plurality of semiconductor integrated circuit devices. In general a semiconductor integrated circuit device (IC) used in various types of system such as a personal digital assistant includes devices which are operated with various voltages such as 5V, 3V, 2.5V, or 1.8V.

BACKGROUND OF THE INVENTION

When semiconductor integrated circuit devices operating at different voltages are mounted on one board to form a system, then at least one regulator is provided on this board. The supply voltage that is provided to the board is stepped up or stepped down with the help of this regulator to obtain a desired supply voltage. The supply voltage is then provided to the semiconductor integrated circuit devices.

In an advanced semiconductor integrated circuit device such as a system LSI or a microcomputer, a circuit as a part of the semiconductor integrated circuit device is sometimes operated at a voltage Vdd2 which is different from a supply voltage Vdd1 provided by an external circuit. Such a provision is made in the viewpoint of restriction on the transistor against pressure, suppression of the power consumption, and to insure the working speed.

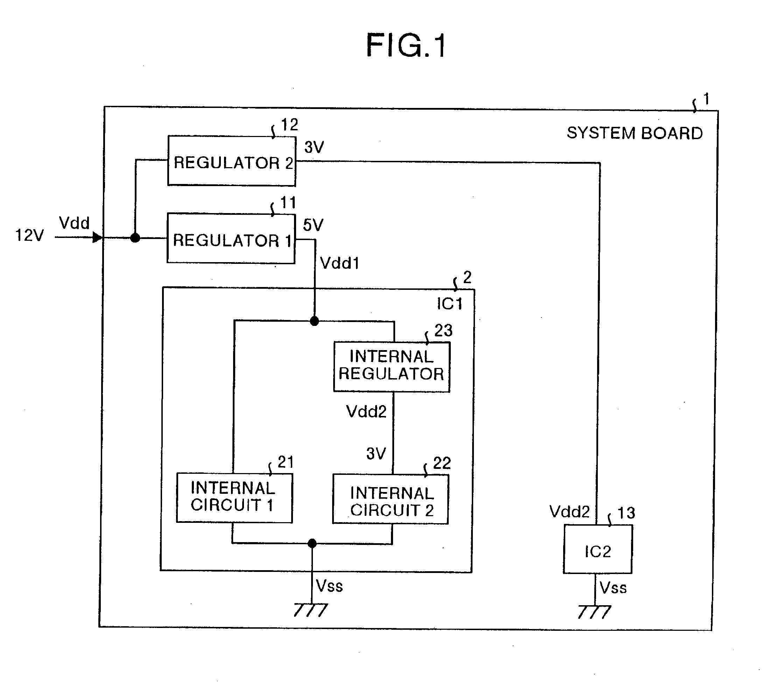

Fig. 1 is a block diagram showing schematic configuration of an electronic circuit based on the conventional technology which is operated with a plurality of supply voltages. Specifically, Fig. 1 shows the schematic configuration of the conventional type of electronic circuit in which a semiconductor integrated circuit device with internal circuits each operated with a different supply voltage as described above is mounted and which is operated with a plurality of supply voltages.

As shown in Fig. 1, the electronic circuit has a system board 1 comprising a printed circuit board to which a 12V supply voltage Vdd is provided from an external circuit. The system board 1 has a first regulator 11 which steps down the supply voltage Vdd of 12V to 5V, and a second regulator 12 is provided which steps down the supply voltage Vdd of 12V to 3V. A first semiconductor integrated circuit device (IC1) 2 receives the 5V supply voltage Vddl, and a second semiconductor integrated circuit device (IC2) 13 receives the 3V supply voltage Vdd2. The first regulator 11, second regulator 12, first semiconductor integrated circuit device 2 and second semiconductor integrated circuit device 13 are mounted on the system board 1.

The first semiconductor integrated circuit device 2 has a first internal circuit (internal circuit 1) 21 which is operated with the 5V supply voltage Vddl, a second internal circuit (internal circuit 2) 22 which is operated with the 3V supply voltage Vdd2, and an internal regulator 23 which steps the 5V supply voltage to 3V. Thus, the second internal circuit 22 is provided with the 3V supply voltage from the internal regulator 23.

The internal regulator 23 in the first semiconductor integrated circuit device 2, however, is specifically provided in order to supply the voltage Vdd2 to the internal circuit 22. Therefore, even if the second internal circuit 22 in the first semiconductor integrated circuit device 2 and the second semiconductor integrated circuit device 13 operate with the same supply voltage Vdd2 of 3V, it is necessary to provide the regulators 23 and 12 each of which generates the 3V supply voltage Vdd2.

It is not known that the semiconductor integrated circuit device 2 has the internal regulator 23 and the internal circuits 21, 22 which are operated with supply voltages Vdd1 and Vdd2 respectively. Therefore, when designing a system in which the first and second semiconductor integrated circuit devices 2, 13 are used, it is common for a designer of the system to mount the regulator 12 for the second semiconductor integrated circuit device 13 on the system board 1.

In general, a switching regulator which obtains a desired output voltage by switching the power at a high frequency (tens of kHz) is used as the regulators 11, 12. Such a switching regulator has a complicated circuit configuration. Further, it comprises a high-frequency transformer, namely a coil, thereby upsizing the system board 1. If this electronic circuit is to be used in portable equipment such as portable phones or personal digital assistance, then the complexity in the configuration and bigger size of the circuit hinder further minimization and weight reduction.

US-5,861,771 discloses a regulator circuit including an output circuit outputting an output voltage based on a control voltage, a reference voltage generating circuit generating a reference voltage, an output voltage control circuit comparing the reference voltage with a voltage depending on the output voltage and producing the control voltage based on a comparison result, and a power supply circuit which supplies the reference voltage generating circuit and the output voltage control circuit with a first power supply voltage which is different from a second power supply voltage supplied to the output circuit.

**Summary of the invention**

It is an object of this invention to provide a semiconductor integrated circuit device with an internal regulator which can use an output voltage from the internal regulator as power for driving another external circuit as well as to provide an electronic circuit and a system board with the semiconductor integrated circuit device provided therein.

To achieve the above object, the invention concerns a semiconductor integrated circuit according to claim 1.

The regulator may be formed with a series regulator.

According to the above invention, in the semiconductor integrated circuit device having the internal regulator, the output voltage of the internal regulator can be used both as power for driving an external circuit and as a regulator for at least one internal circuit, whereas at least one other internal circuit operates with the input voltage.

The invention also concerns an electronic circuit according to claim 3. Thus, an output voltage of a regulator internally formed in a first semiconductor integrated circuit device according to the invention is used to drive a second semiconductor integrated circuit device by this output voltage.

According to the above invention, the second semiconductor integrated circuit device is driven with supply voltage provided by the first semiconductor integrated circuit device. Therefore, there is no need to mount a regulator on the system board for providing supply voltage to the second semiconductor integrated circuit device.

Other objects and features of this invention will become apparent from the following description with reference to the accompanying drawings.

BRIEF DESCRIPTION OF THE DRAWINGS

Fig. 1 is a block diagram showing schematic configuration of the electronic circuit based on the conventional technology which is operated with a plurality of supply voltages;

Fig. 2 is a block diagram showing schematic configuration of one example of the semiconductor integrated circuit device, the electronic circuit and the system board according to the present invention;

Fig. 3 is a schematically shows the embodiment of the internal regulator of the semiconductor integrated circuit device according to the present invention; and

Fig. 4 is a table showing an example of the output characteristics of the semiconductor integrated circuit device according to the present invention.

DESCRIPTION OF THE PREFERRED EMBODIMENTS

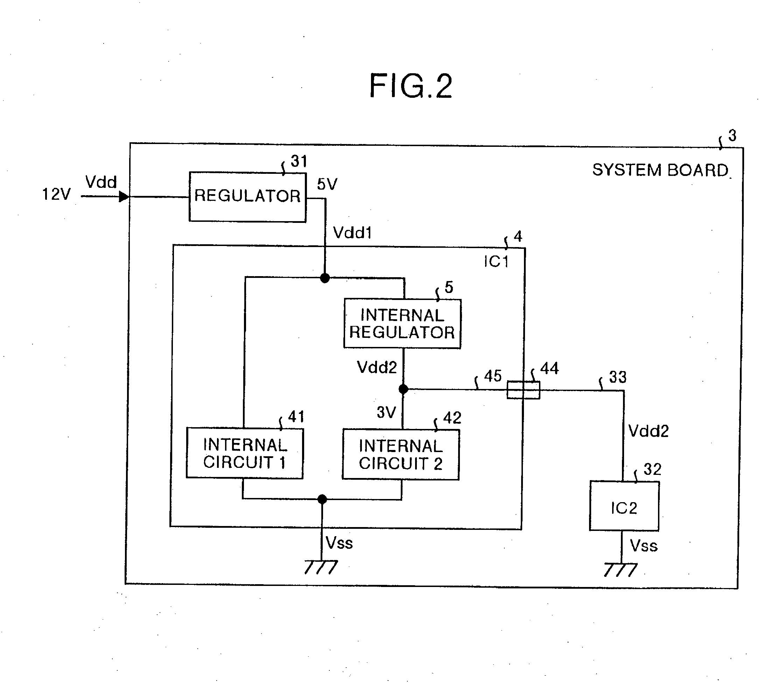

The semiconductor integrated circuit device, the electronic circuit, the system board and the method of supplying power to a plurality of semiconductor integrated circuit devices according to an embodiment of the present invention are explained in detail below with reference to Fig. 2 to Fig. 4.

Fig. 2 is a block diagram showing schematic configuration of an example of the semiconductor integrated circuit device the electronic circuit, and the system board according to the present invention. A system board 3 shown in Fig. 2 has a printed circuit board to which a supply voltage Vdd of, for instance, 12V is provided from an external circuit. This system board has a regulator 31 that steps down the supply voltage Vdd of 12V to 5V. A first semiconductor integrated circuit device (IC1) 4 receives the supply voltage of 5V. A second semiconductor integrated circuit device (IC2) 32 receives a supply voltage of, for instance, 3V. The regulator 31, the first semiconductor integrated circuit device 4 and the second semiconductor integrated circuit device 32 are mounted on the system board 3.

The first semiconductor integrated circuit device 4 comprises a first internal circuit (internal circuit 1) 41 which is operated with a supply voltage Vdd1 of 5V, a second internal circuit (internal circuit 2) 42 which is operated with a supply voltage Vdd2 of 3V, and an internal regulator 5 which steps down 5V to 3V. The first semiconductor integrated circuit device 4 further comprises an external power terminal 44 for outputting the output voltage of the internal regulator 5, namely outputting the voltage of 3V as a supply voltage to the outside. The second internal circuit 42 is driven with the 3V supply voltage Vdd2 provided from the internal regulator 5.

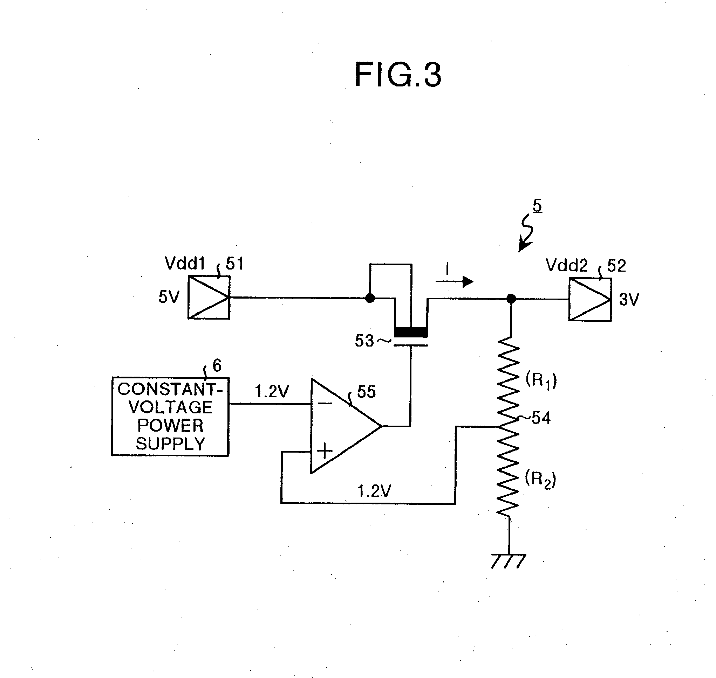

The external power terminal 44 is electrically connected to an output terminal 52 (see Fig. 3 which is described later) of the internal regulator 5 through a signal line 45. The signal line 45 is formed together with the formation of interconnections (not shown) between transistors constituting the first semiconductor integrated circuit device 4 in the device process.

Namely, a resist mask is obtained by the steps of forming transistors or the like on a semiconductor substrate using the known technology, depositing a metal pattern layer on top of these transistors, further covering a resist over the metal pattern layer, and performing exposure and development of the resist using a mask with metal patterns for the transistors and the signal line 45. The signal line 45 is obtained by removing the unnecessary portion of the metal pattern layer by etching and then removing the residual resist. The signal line 45 is formed so as to have a line width such that the line can resist a supply voltage Vdd2 of 3V.

The external power terminal 44 and the power terminal (not shown) of the second semiconductor integrated circuit device 32 are electrically connected to each other through a signal line 33 printed on the system board 3. The signal line 33 is formed together with the other signal lines on the system board 3 by means of printing technology so as to have a line width such that the line can resist a supply voltage Vdd2 of 3V. A capacitor for noise removal or the like may be connected to the signal line 33 or to the external power terminal 44 of the first semiconductor integrated circuit device 4.

Fig. 3 schematically shows an embodiment of the internal regulator 5. In this embodiment, the internal regulator 5 is formed with a series regulator. As shown in Fig. 3, this internal regulator 5 has input terminal 51, output terminal 52, P-channel field effect transistor 53 as a control resistor, resistance load 54, and operational amplifier 55. The source of the field effect transistor 53 is connected to the input terminal 51 and ed to the output terminal 52.

Output voltage of the operational amplifier 55 is applied to the gate terminal of the field effect transistor 53. The resistance of the field effect transistor 53 is controlled by the output voltage of the operational amplifier 55, by which the current I passing through this transistor is adjusted. Power consumption of the field effect transistor 53 is controlled through the adjustment to the current I, and a voltage of 3V is output from the output terminal 52 of the internal regulator 5.

The constant-voltage power supply 6 supplies a reference voltage of, for instance, 1.2V to the inverted input terminal of the operational amplifier 55. A voltage generated by the current passing through the load 54 is applied to the noninverted input terminal of the operational amplifier 55. The load 54 is placed in such a manner that the voltage generated by the current passing through the load 54 will be just, for instance, 1.2V at the moment at which the voltage at the output terminal 52 is 3V. Namely, assuming that the resistance on the positive side of the divided load 54 to be $R_1$ and the resistance on the grounded side to be $R_2$, there is a relation between $R_1$ and $R_2$ as shown in the following equation.

$$R_2 \; / \; (R_1 + R_2) \; \times \; 3V \; = \; 1.2V$$

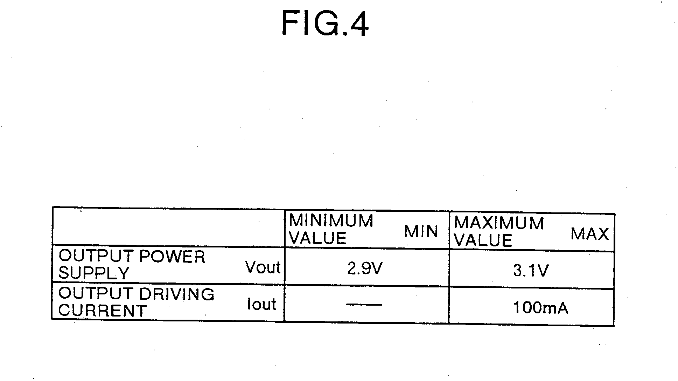

Fig. 4 is a table showing an example of the output characteristics of the semiconductor integrated circuit device according to the present invention. Specifically, Fig. 4 shows one example of output characteristics of the internal regulator 5, namely of characteristics of the supply voltage output from the first semiconductor integrated circuit device 4 to the outside. The circuit device has the characteristics such that the output voltage $V_{out}$ is, for instance, from 2.9V to 3.1V and the maximum value of an output driving current $I_{out}$ is 100 mA. In this embodiment, such a table in which the specifications are described is provided along with the first semiconductor integrated circuit device 4.

This specification table is referred to by the designer when he/she designs a system for a portable telephone or a portable type of computer called PDA (personal digital assistant) using the first semiconductor integrated circuit device 4.

The regulator 31, comprises a switching regulator which is formed with a switching transistor, a pulse-width control circuit for controlling the time ratio (duty ratio) of ON versus OFF of the transistor, and a high-frequency transformer. However, the configuration is not limited to this.

According to this embodiment, since the first semiconductor integrated circuit device 4 has an internal regulator 5 and further has an external power terminal 44 for outputting the output voltage of the internal regulator 5 to the outside, the circuit device can provide the output voltage of the internal regulator 5 as a supply voltage for driving an external circuit.

Thus, the second semiconductor integrated circuit device 32 on the same system board 3 can be driven with the supply voltage provided from the first semiconductor integrated circuit device 4. Therefore, the system board 3 requires no regulator dedicated to supply the voltage to the second semiconductor integrated circuit device 32 to be mounted thereon. Resultantly, the system board 3 can be made smaller. Further, the portable equipment, for example, in which this system board 3 is used can be reduced in size and weight.

Although it is mentioned in this embodiment that the first semiconductor integrated circuit device 4 outputs a supply voltage of 3V to the outside, the value of the voltage is not limited to this. A plurality of supply voltages such as 5V, 3V, 2.5V, and 1. 8V may be output to the outside. In such a case, external power terminals corresponding to each supply voltages are provided.

In addition, although it is mentioned in this embodiment that the internal regulator 5 steps down the input voltage for output, However, the regulator may step up the input voltage.

Further, in the above-mentioned embodiment, although the internal regulator 5 is formed with a series regulator, the regulator is not to be thus limited but any other circuit may be employed as long as such circuit generates a stable direct voltage.

As described above, with the present invention, it is possible to obtain the semiconductor integrated circuit device which has the internal regulator and outputs the output voltage of this internal regulator to the external circuit as supply voltage for driving the external circuit. Therefore, a different semiconductor integrated circuit device on the same system board can be driven with the supply voltage provided from this semiconductor integrated circuit device, so that the need for a regulator dedicated to supply the voltage to the different semiconductor integrated circuit device mentioned above is eliminated. Resultantly, the system board can be made smaller.

Although the invention has been described with respect to a specific embodiment for a complete and clear disclosure, the appended claims are not to be thus limited but are to be construed as embodying all modifications and alternative constructions that may occur to one skilled in the art which fairly fall within the basic teaching herein set forth.

**Claims**

**1.** An electronic circuit comprising:

a first semiconductor integrated circuit device (4) configured to be operated by a first voltage (Vdd1), the first semiconductor integrated circuit device comprising:

at least one regulator (5) configured to step up or down the first voltage (Vdd1) to convert the first voltage to a second voltage (Vdd2) different from the first voltage and to output the second voltage; and

a plurality of internal circuits (41, 42), wherein at least one of said internal circuits (41) is configured to be driven by the first voltage(Vdd1) and at leastanother one of said internal circuits (42) is configured to be driven by the second voltage (Vdd2) output by said regulator; and

a second semiconductor integrated circuit device (32) configured to be operated by a second voltage (Vdd2),

**characterized in that**

the first semiconductor integrated circuit device (4) further comprises an output terminal (44) configured to receive the second voltage from the regulator and to output the received second voltage to the outside of the first semiconductor integrated circuit device, and

the second semiconductor integrated circuit device is connected to the output terminal and configured to be operated by the second voltage output from the output terminal.

2. An electronic circuit as in claim 1, said regulator being formed of a series regulator.

3. An electronic circuit as in claim 1 or 2, further comprising an external regulator (31) that steps up or steps down an input voltage to be transformed to an output voltage different from the input voltage, the first semiconductor integrated circuit device (4) receiving the voltage output by said external regulator.

4. An electronic circuit as in anyone of claims 1 to 3 comprising

- a plurality of semiconductor integrated circuit devices, each device being operated with a different supply voltage,

- wherein said semiconductor integrated circuit devices are connected to each other in such a manner that an input of a semiconductor integrated circuit device is connectecj to the power output terminal of another semiconductor integrated circuit device and is driven with the supply voltage from said power output terminal.

5. A system board comprising:

- an external regulator (31) that steps up or steps down an input voltage to be transformed to an output voltage different from the input voltage; and

- an electronic circuit as in anyone of claims 1 to 4, one of said semiconductor integrated circuit devices receiving the voltage output by said external regulator.

**Patentansprüche**

1. Elektronische Schaltung mit:

einer ersten Halbleiter-IC-Vorrichtung (4), die zum Betrieb mit einer ersten Spannung (Vdd1) konfiguriert ist, wobei die erste Halbleiter-IC-Vorrichtung aufweist:

mindestens einen Regler (5), der konfiguriert ist zum Erhöhen oder Absenken der ersten Spannung (Vdd1), um die erste Spannung zu einer zweiten Spannung (Vdd2), die sich von der ersten Spannung unterscheidet, zu konvertieren und die zweite Spannung auszugeben; und

mehreren internen Schaltungen (41, 42), wobei mindestens eine der internen Schaltungen (41) derart konfiguriert ist, dass sie durch die erste Spannung (Vdd1) gesteuert wird, und mindestens eine weitere der internen Schaltungen (42) derart konfiguriert ist, dass sie durch die von dem Regler ausgegebene zweite Spannung (Vdd2) gesteuert wird; und

einer zweiten Halbleiter-IC-Vorrichtung (32), die zum Betrieb mit einer zweiten Spannung (Vdd2) konfiguriert ist,

**dadurch gekennzeichnet, dass**

die erste Halbleiter-IC-Vorrichtung (4) ferner einen Ausgangsanschluss (44) aufweist, der konfiguriert ist zum Empfangen der zweiten Spannung von dem Regler und zum Ausgeben der empfangenen zweiten Spannung in den Bereich außerhalb der ersten Halbleiter-IC-Vorrichtung, und

die zweite Halbleiter-IC-Vorrichtung mit dem Ausgangsanschluss verbunden ist und zum Betrieb mit der von dem Ausgangsanschluss ausgegebenen zweiten Spannung konfiguriert ist.

2. Elektronische Schaltung nach Anspruch 1, bei der der Regler als Serien-Regler ausgebildet ist.

3. Elektronische Schaltung nach Anspruch 1 oder 2, ferner mit einem externen Regler (31), der eine Eingangsspannung, die zu einer sich von der Eingangsspannung unterscheidenden Ausgangsspannung transformiert werden soll, erhöht oder absenkt, wobei die erste Halbleiter-IC-Vorrichtung (4) die von dem externen Regler ausgegebene Spannung empfängt.

**4.** Elektronische Schaltung nach einem der Ansprüche 1 bis 3, mit

- mehreren Halbleiter-IC-Vorrichtungen, wobei jede Vorrichtung mit einer unterschiedlichen Versorgungsspannung betrieben wird,
- wobei die Halbleiter-IC-Vorrichtungen derart miteinander verbunden sind, dass ein Eingang einer Halbleiter-IC-Vorrichtung mit dem Leistungsausgangsanschluss einer weiteren Halbleiter-IC-Vorrichtung verbunden ist und mit der Versorgungsspannung des Leistungsausgangsanschlusses gesteuert wird.

**5.** Systemplatine mit:

- einem externen Regler (31), der eine Eingangsspannung, die zu einer sich von der Eingangsspannung unterscheidenden Ausgangsspannung transformiert werden soll, erhöht oder absenkt; und
- einer elektronische Schaltung nach einem der Ansprüche 1 bis 4, wobei eine der Halbleiter-IC-Vorrichtungen die von dem externen Regler ausgegebene Spannung empfängt.

**Revendications**

**1.** Circuit électronique comprenant :

un premier dispositif à circuits intégrés à semi-conducteur (4) configuré pour être commandé par une première tension (Vdd1), le premier dispositif à circuits intégrés à semi-conducteur comprenant :

au moins un régulateur (5) configuré pour élever ou abaisser la première tension (Vdd1) afin de convertir la première tension en une seconde tension (Vdd2) différente de la première tension et pour délivrer en sortie la seconde tension ; et une pluralité de circuits internes (41, 42), l'un au moins desdits circuits internes (41) étant configuré pour être attaqué par la première tension (Vdd1) et au moins un autre desdits circuits internes (42) étant configuré pour être attaqué par la seconde tension (Vdd2) délivrée en sortie par ledit régulateur, et un second dispositif à circuits intégrés à semi-conducteur (32) configuré pour être commandé par une seconde tension (Vdd2), **caractérisé en ce que** le premier dispositif à circuits intégrés à semi-conducteur (4) comprend en outre une borne de sortie (44) configurée pour recevoir la seconde tension du régulateur et pour délivrer la seconde tension reçue en sortie du premier dispositif à circuits intégrés à semiconducteur, et le second dispositif à circuits intégrés à semi-conducteur est relié à la borne de sortie et configuré pour être commandé par la seconde de tension délivrée par la borne de sortie.

**2.** Circuit électronique selon la revendication 1, ledit régulateur étant formé d'un régulateur série.

**3.** Circuit électronique selon la revendication 1 ou 2, comprenant en outre un régulateur externe (31) qui élève ou abaisse une tension d'entrée pour la transformer en une tension de sortie différente de la tension d'entrée, le premier dispositif à circuits intégrés à semi-conducteur (4) recevant la tension délivrée en sortie par ledit régulateur externe.

**4.** Circuit électronique selon l'une quelconque des revendications 1 à 3, comprenant

- une pluralité de dispositifs à circuits intégrés à semi-conducteur, chaque dispositif étant commandé par une tension d'alimentation différente,
- lesdits dispositif à circuits intégrés à semi-conducteur étant reliés entre eux de manière à ce qu'une entrée d'un dispositif à circuits intégrés à semi-conducteur soit reliée à la borne de sortie de puissance d'un autre dispositif à circuits intégrés à semi-conducteur et soit attaquée par la tension d'alimentation provenant de ladite borne de sortie de puissance.

**5.** Carte de système comprenant :

- un régulateur externe (31) qui élève ou abaisse la tension d'entrée pour la transformer en une tension de sortie différente de la tension d'entrée ; et
- un circuit électronique selon l'une quelconque des revendications 1 à 4, l'un desdits dispositifs à circuits intégrés à semi-conducteur recevant la tension délivrée en sortie par ledit régulateur externe.

# FIG.1

EP 1 046 975 B1

# FIG.2

EP 1 046 975 B1

# FIG.3

Vdd1 51
5V

Vdd2 52
3V

I

53~

CONSTANT-
VOLTAGE
POWER
SUPPLY

6

1.2V

55

1.2V

$(R_1)$

~54

$(R_2)$

5

EP 1 046 975 B1

# FIG.4

| | | MINIMUM VALUE MIN | MAXIMUM VALUE MAX |
|---|---|---|---|
| OUTPUT POWER SUPPLY | Vout | 2.9V | 3.1V |
| OUTPUT DRIVING CURRENT | Iout | —— | 100mA |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5861771 A